# EUROPEAN PATENT APPLICATION

(11) **EP 2 801 969 A1**
(43) Date of publication of application: **12.11.2014**
(21) Application number: 14162813.1
(22) Date of filing: 31.03.2014
(51) Int. Cl.: G09G 3/32, G09G 3/20

(54) **Pixel of an organic light emitting display device and organic light emitting display device**

(30) Priority: 10.05.2013 KR 20130052925
(71) Applicant: Samsung Display Co., Ltd., Gyeonggi-Do (KR)
(72) Inventor: Choi, Yang-Hwa, Gyeonggi-do (KR)
(74) Representative: Mounteney, Simon James

(57) **Abstract**

A pixel of an organic light emitting display device (200) includes a first capacitor (292), second capacitor (294), and a number of transistors (210, 220, 230, 240, 250, 260, 280). The first capacitor (292) stores an emission data voltage from a data line (DATA_L) to set the driving current for the OLED. The second capacitor (294) stores a scan data voltage from the data line (DATA_L) to set the OLED to on / off during a sub-frame. A switching transistor (240) is selectively turned on or off in response to the scan data voltage stored in the second capacitor (294). When the switching transistor (240), the driving transistor (210) and the light emission control transistor (260) are turned on, an organic light emitting diode (270) is driven to display an image using a plurality of sub-frames. During a refresh sub-frame, the degradation of the OLED (270) in the pixel is measured via the sense transistor (250) and the emission data voltage adjusted accordingly.

## Description

### BACKGROUND

### 1. Field

The invention relates to a display device.

### 2. Description of the Related Art

An active matrix type of organic light emitting display device may be driven with an analog driving method or a digital driving method. An analog driving method produces grayscale values with a variable voltage level of data. However, to implement a display device using this method, the driving integrated circuit (IC) must have a large size, which may be difficult to manufacture. Also, it is difficult to manufacture such a display device with high resolution.

The digital driving method produces grayscale values with a variable time duration for which an organic light emitting diode (OLED) emits light. A digitally driven display device may have a simpler IC structure. Therefore, it may be easier to implement a higher-resolution display device using the digital driving method compared to an analog-driven display device. A digitally driven display device may also be more suitable for implementing larger panels.

However, in the digital driving method, a desired luminance of an image may not be displayed because of changes in efficiency caused by degradation of the OLEDs in the display pixels. In other words, the OLED in one or more pixels may degrade over time, and thus a desired luminance of an image may not be displayed. As this degradation continues, the lifetime of the OLEDs may be reduced, thereby permanently affecting the display device in an adverse manner.

The present invention sets out to overcome this problem with the prior art.

### SUMMARY

In accordance with one embodiment of the invention, a pixel of an organic light emitting display device may include a first switching transistor configured to be turned on in response to a switching signal; a first storage capacitor configured to store an emission data voltage applied through a data line while the first switching transistor is turned on; a driving transistor configured to be turned on in response to the emission data voltage stored in the first storage capacitor; a second switching transistor configured to be turned on in response to a scan signal; a second storage capacitor configured to store a scan data voltage applied through the data line while the second switching transistor is turned on; a third switching transistor coupled in series to the driving transistor and configured to be selectively turned on or off in response to the scan data voltage stored in the second storage capacitor; and an organic light emitting diode configured to be driven by the turned-on driving transistor when the third switching transistor is turned on.

The driving transistor may operate in a saturation region based on the emission data voltage, and the third switching transistor may operate in a linear region based on the scan data voltage.

The first switching transistor may include a gate terminal to which the switching signal is applied, a first terminal coupled to the data line, and a second terminal coupled to a first node, the first storage capacitor may include a first electrode coupled to a first power supply voltage and a second electrode coupled to the first node, and the driving transistor may include a gate terminal coupled to the first node, a first terminal coupled to the first power supply voltage, and a second terminal.

The second switching transistor may include a gate terminal to which the scan signal is applied, a first terminal coupled to the data line, and a second terminal coupled to a second node, the second storage capacitor may include a first electrode coupled to the first power supply voltage, and a second electrode coupled to the second node, and the third switching transistor may include a gate terminal coupled to the second node, a first terminal coupled to the second terminal of the driving transistor, and a second terminal.

The organic light emitting diode may include an anode electrode coupled to the second terminal of the third switching transistor and a cathode electrode coupled to a second power supply voltage, and the second power supply voltage may have substantially a same voltage level as the first power supply voltage while the emission data voltage is stored in the first storage capacitor and while the scan data voltage is stored in the second storage capacitor.

An emission control transistor may be coupled between the second terminal of the third switching transistor and the organic light emitting diode. The emission control transistor may be configured to transfer a driving current generated by the turned-on driving transistor to the organic light emitting diode in response to an emission control signal, and the organic light emitting diode may be configured to emit light based on the driving current transferred through the emission control transistor.

The emission control transistor may include a gate terminal to which an emission control signal is applied, a first terminal coupled to the second terminal of the third switching transistor, and a second terminal coupled to the organic light emitting diode.

The emission data voltage may be adjusted to compensate for the degradation of the organic light emitting diode. The emission data voltage may be adjusted based on the current detected by the sensing transistor, the adjusted emission data voltage compensating for a degradation of the organic light emitting diode.

The pixel may further include a sensing transistor configured to detect a current flowing through the organic light emitting diode. The sensing transistor may include a gate terminal to which a sensing signal is applied, a first terminal coupled to the data line, and a second terminal coupled to an anode electrode of the organic light emitting diode.

At least some of the above and other features of the invention are set out in the claims.

### BRIEF DESCRIPTION OF THE DRAWINGS

Features of the invention will become apparent to those of ordinary skill in the art upon referring to he following embodiments of the invention, which are described with reference to the attached drawings in which:
FIG. 1 illustrates an embodiment of a frame for driving an organic light emitting display device;
FIG. 2 illustrates an embodiment of a pixel of an organic light emitting display device;
FIG. 3 is a timing diagram for describing an operation of a pixel of FIG 2;
FIG. 4 illustrates another embodiment of a pixel of an organic light emitting display device;
FIG. 5 is a timing diagram for describing an operation of a pixel of FIG 4;
FIG. 6 illustrates another embodiment of a frame for driving an organic light emitting display device;
FIG. 7 illustrates a pixel of an organic light emitting display device;
FIG. 8 is a timing diagram for describing an operation of a pixel of FIG 7;
FIG. 9 illustrates another embodiment of a pixel of an organic light emitting display device;
FIG. 10 is a timing diagram for describing an operation of a pixel of FIG 9; and
FIG. 11 illustrates an embodiment of an organic light emitting display device.

### DETAILED DESCRIPTION

Example embodiments will now be described more fully hereinafter with reference to the accompanying drawings; however, the invention may be embodied in different forms and should not be construed as limited to the embodiments set forth herein. Rather, these embodiments are provided so that this disclosure will be thorough and will fully convey example implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

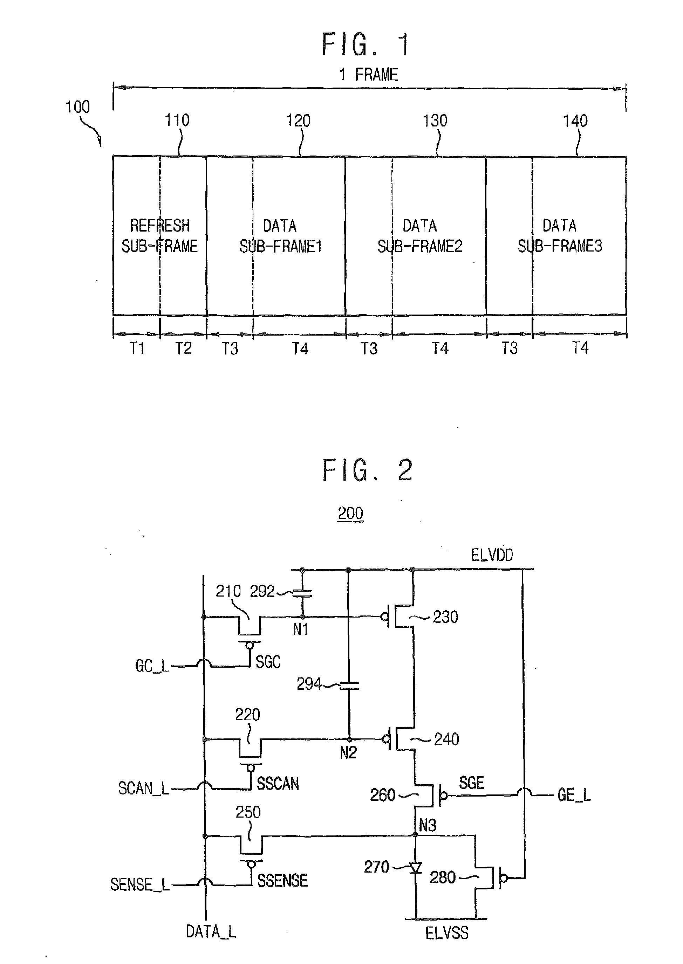

FIG. 1 illustrates an embodiment of a frame 100 for driving an organic light emitting display device. Referring to FIG. 1, an organic light emitting display device driven by frame 100 may perform a digital driving method that produces grayscale values with a variable time duration for each of a plurality of pixels.

As shown, frame 100 may be divided into at least one refresh sub-frame 110 and a plurality of data sub-frames 120, 130 and 140. The refresh sub-frame 110 may include an initializing period T1 during which an emission data voltage is applied to and stored in the plurality of pixels. The refresh sub-frame 110 may further include a sensing period T2 during which the degradation of an organic light emitting diode of each pixel is detected. Each data sub-frame 120, 130 and 140 may include a scan period T3 during which a scan data voltage is applied to each pixel, and an emission period T4 during which the organic light emitting diode of each pixel emits light. In FIG. 1, one refresh sub-frame and three data sub-frames are shown. However in other embodiments, the frame may include a different number of refresh and/or data sub-frames.

In the initializing period T1 of each refresh sub-frame 110, a switching signal may be applied to the plurality of pixels at substantially the same time, and the emission data voltage may be received and stored from a data driver. At this time, the emission data voltage may have a voltage level that allows a driving transistor of each pixel to operate in a saturation region and that allows the organic light emitting diode to emit light in response to a driving current generated by the driving transistor. In accordance with one embodiment, the emission data voltage may be adjusted to compensate for degradation of an organic emitting light diode detected during the refresh sub-frame 110 of a previous frame. In FIG. 1, the duration of periods T1 and T2 in the refresh sub-frame are shown to be equal. However, in other embodiments, periods T1 and T2 may have different durations.

In the sensing period T2 of each refresh sub-frame 110, a sensing signal may be applied sequentially row-by-row to the plurality of pixels, and the degradation of the organic light emitting diode of each pixel may be detected to reflect the detected degradation into the emission data voltage of the next frame. Accordingly, since the degradation of the organic light emitting diode is compensated, a life time of the pixel may be increased.

In the scan period T3 of each data sub-frame 120, 130 and 140, a scan signal from a scan driver may be applied sequentially row-by-row to the plurality of pixels, and the plurality of pixels may receive and store a scan data voltage transmitted from the data driver. At this time, the scan data voltage may have a voltage level that allows a third switching transistor coupled in series to the driving transistor to operate in a linear region. Further, the scan data voltage applied to each pixel may be either a turn-on voltage that turns on the third switching transistor during the emission period T4 or a turn-off voltage that turns off the third switching transistor during the emission period T4.

In the emission period T4 of each data sub-frame 120, 130 and 140, an emission control signal may be applied to the plurality of pixels at substantially the same time, and the organic light emitting diode of each pixel may emit light or not emit light in response to the stored emission data voltage and the stored scan data voltage. In some embodiments, as illustrated, for example, in FIG. 1, the plurality of pixels included in the organic light emitting display device may perform simultaneous light emission in response to the emission control signal SGE that is applied to the plurality of pixels at substantially the same time.

As described above, an organic light emitting display device according to one embodiment may divide one frame 100 into at least one refresh sub-frame 110 and a plurality of data sub-frames 120, 130 and 140. In the refresh sub-frame 110, the emission data voltage V_DATA is applied to the driving transistor. The emission data voltage V_DATA may have a voltage level that makes the driving transistor operate in the saturation region and that makes the organic light emitting diode emit light. Further, in the refresh sub-frame 110, the degradation of the organic light emitting diode may be detected and may be reflected into the emission data voltage V_DATA of the next frame. Accordingly, since the degradation of the organic light emitting diode of each pixel is compensated, a life time of the pixel may be increased.

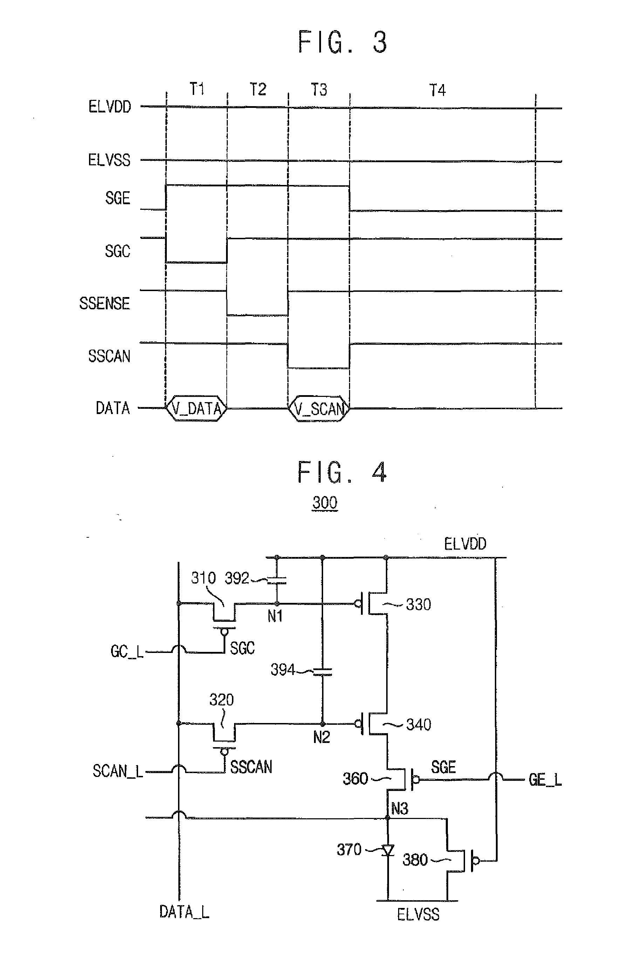

FIG. 2 is a circuit diagram illustrating an embodiment of a pixel of an organic light emitting display device, and FIG. 3 is a timing diagram for describing operation of a pixel of FIG. 2.

Referring to FIG. 2, a pixel of the organic light emitting display device 200 includes first through third switching transistors 210, 220 and 240, a driving transistor 230, a sensing transistor 250, a leakage current compensating transistor 280, an emission control transistor 260, first and second storage capacitors 292 and 294, and an organic light emitting diode 270. In some example embodiments, the plurality of switching transistors 210, 220 and 240, the driving transistor 230, the sensing transistor 250, the leakage current compensating transistor 280, and the emission control transistor 260 may be implemented as PMOS transistors or NMOS transistors, or a combination of both.

The first switching transistor 210 may transfer an emission data voltage V_DATA to a first node N1 in response to a switching signal SGC. According to some example embodiments, the switching signal SGC may be generated and applied from an external circuit of a display panel or a scan driving part (or a scan driver) of the display panel. In some example embodiments, the switching signal SGC may be applied to the plurality of pixels included in the organic light emitting display device at substantially the same time. In other example embodiments, the switching signal SGC may be applied sequentially row-by-row to the plurality of pixels. For example, the first switching transistor 210 may have a gate terminal coupled to a switching line GC_L, a first terminal coupled to a data line DATA_L, and a second terminal coupled to the first node N1.

The first storage capacitor 292 may store the emission data voltage V_DATA that is transferred to the first node N1 by the first switching transistor 210. The emission data voltage V_DATA may have a voltage level that allows the driving transistor 230 to operate in a saturation region and that allows the organic light emitting diode to emit light by a driving current generated by the driving transistor 230.

The second switching transistor 220 may transfer the scan data voltage V_SCAN to a second node N2 in response to a scan signal SSCAN. At this time, the scan signal SSCAN may be applied from the scan driver sequentially row-by-row to the plurality of pixels. For example, the second switching transistor 220 may have a gate terminal coupled to a scan line SCAN_L, a first terminal coupled to the data line DATA_L, and a second terminal coupled to the second node N2.

The second storage capacitor 294 may store the scan data voltage V_SCAN that is transferred to the second node N2 by the second switching transistor 220. The scan data voltage V_SCAN may have a voltage level that allows the third switching transistor 240 to operate in a linear region and that allows the third switching transistor 240 to be turned on or off in the emission period T4.

The driving transistor 230 may be turned on in response to the emission data voltage V_DATA stored in the first storage capacitor 292. For example, the driving transistor 230 may have a gate terminal coupled to the first node N1, a first terminal coupled to a first power supply voltage ELVDD, and a second terminal coupled to a first terminal of the third switching transistor 240.

The third switching transistor 240 may control the organic light emitting diode 270 to emit light or not to emit light. This may be accomplished by forming or blocking a path of the driving current flowing, from the first power supply voltage ELVDD through the driving transistor 230, the third switching transistor 240, the emission control transistor 260, and the organic light emitting diode 270, to a second power supply voltage ELVSS based on the scan data voltage V_SCAN stored in the second storage capacitor 294.

For example, if the scan data voltage V_SCAN stored in the second storage capacitor 294 is a turn-on voltage, the third switching transistor 240 allows the organic light emitting diode 270 to emit light by forming the path of the driving current. If the scan data voltage V_SCAN stored in the second storage capacitor 294 is a turn-off voltage, the third switching transistor 240 allows the organic light emitting diode 270 not to emit light by blocking the path of the driving current. For example, the third switching transistor 240 may have a gate terminal coupled to the second node N2, the first terminal coupled to the second terminal of the driving transistor 230, and a second terminal coupled to a first terminal of the emission control transistor 260.

The organic light emitting diode 270 may emit light in response to the driving current from the first power supply voltage ELVDD through the driving transistor 230, the third switching transistor 240, emission control transistor 260, and the organic light emitting diode 270 to the second power supply voltage ELVSS. For example, the organic light emitting diode 270 may have an anode electrode coupled to a third node N3 and a cathode electrode coupled to the second power supply voltage ELVSS.

The leakage current compensating transistor 280 may compensate for a black luminance by compensating for the leakage current at the organic light emitting diode 270. For example, the leakage current compensating transistor 280 may have a gate terminal coupled to the first power supply voltage ELVDD, a first terminal coupled to the third node N3, and a second terminal coupled to the second power supply voltage ELVSS.

The sensing transistor 250 may be turned on in response to the sensing signal SSENSE. At this time, the sensing signal SSENSE may be applied from the scan driver sequentially row-by-row to the plurality of pixels. For example, the sensing transistor 250 may have a gate terminal coupled to a sensing line SENSE_L, a first terminal coupled to the data line DATA_L, and a second terminal coupled to the anode electrode of the organic light emitting diode 270.

The emission control transistor 260 may control the organic light emitting diode 270 to emit light or not to emit light. This may be accomplished by forming or blocking the path of the driving current flowing, from the first power supply voltage ELVDD through the driving transistor 230, the third switching transistor 240, the emission control transistor 260, and the organic light emitting diode 270, to the second power supply voltage ELVSS in response to the emission control signal SGE.

In some example embodiments, the emission control signal SGE may be generated from an external circuit of the display panel and may be applied to the plurality of pixels at substantially the same time. For example, the emission control transistor 260 may have a gate terminal coupled to an emission control line GE_L, a first terminal coupled to the second terminal of the third switching transistor 240, and a second terminal coupled to the anode electrode of the organic light emitting diode 270.

In the organic light emitting display device according to example embodiments, a frame may be divided into a refresh sub-frame and a plurality of data sub-frames. In the refresh sub-frame, the emission data voltage V_DATA may allow driving transistors 230 of all pixels included in the organic light emitting display device to operate in the saturation region. Further, the degradation of the organic light emitting diode 270 may be detected in the refresh sub-frame, and thus the organic light emitting diode 270 may emit light with a desired luminance by compensating for the degradation.

Referring to FIGS. 1, 2 and 3, in the initializing period T1 of the refresh sub-frame 110, a low level voltage (e.g., a low gate voltage VGL) may be applied as the switching signal SGC through the switching line GC_L, and the emission data voltage V_DATA may be applied through the data line DL. The first switching transistor 210 may transfer the emission data voltage V_DATA to the first node N1 in response to the low gate voltage VGL. The first storage capacitor 292 may store charges corresponding to a voltage difference between the first power supply voltage ELVDD and a voltage of the first node N1, or the emission data voltage V_DATA. At this time, the emission data voltage V_DATA may have a voltage level which allows the driving transistor 230 to operate in the saturation region.

In the sensing period T2 of the refresh sub-frame 110, the low level voltage may be applied as the sensing signal SSENSE through the sensing line SENSE_L, and thus the anode electrode of the organic light emitting diode 270 and the data line DATA_L may be electrically coupled. The level of the degradation of the organic light emitting diode 270 may be measured by sensing the current flowing between the anode electrode and the cathode electrode of the organic light emitting diode 270. The measurement may be performed, for example, by an external device.

In some example embodiments, the emission data voltage V_DATA of the next frame may be generated by reflecting the measured level of the degradation of the organic light emitting diode 270. In the initializing period T1 of the refresh sub-frame 110 of the next frame, the degradation of the organic light emitting diode 270 may be compensated using the emission data voltage V_DATA where the measured level of the degradation is reflected.

During the initializing period T1 and the sensing period T2 of the refresh sub-frame 110, the emission control transistor 260 may be turned off by applying a high level voltage (e.g., a high gate voltage VGH) as the emission control signal SGE through the emission control line GE_L, and thus the organic light emitting diode 270 may not emit light. In other words, since the emission control transistor 260 is turned off for the organic light emitting diode 270 not to emit light during the refresh sub-frame 110, an image displayed by the organic light emitting display device may not be affected by the refresh sub-frame 110. In some example embodiments, the emission control signal SGE may be generated and applied from an external device, and the emission control signal SGE may be applied to the plurality of pixels at substantially the same time.

In the scan period T3 of each data sub-frame 120, 130 and 140, a low level voltage (e.g., a low gate voltage VGL) may be applied as the scan signal SSCAN through the scan line SL, and the scan data voltage V_SCAN may be applied as the data signal DATA through the data line DL. The scan data voltage V_SCAN may have a voltage level corresponding to a value of a corresponding bit of the input data. The second switching transistor 220 may transfer the scan data voltage V_SCAN to the second node N2 in response to the low gate voltage VGL. The second storage capacitor 294 may store charges corresponding to a voltage difference between the first power supply voltage ELVDD and a voltage of the second node N2, or the scan data voltage V_SCAN. Thus, the voltage of the second node N2 may be maintained as the scan data voltage V_SCAN even though the second switching transistor 220 is turned off.

In the emission period T4 of each data sub-frame 120, 130 and 140, the low level voltage (e.g., low gate voltage VGL) may be applied as the emission control signal SGE through the emission control line GE_L. The emission control transistor 260 may be turned on in respond to the low gate voltage VGL. If the driving transistor 230 is turned on by the voltage of the first node N1 (or, the voltage of the second electrode of the first storage capacitor 292), the third switching transistor 240 is turned on by the voltage of the second node N2 (or, the voltage of the second electrode of the second storage capacitor 294), and the emission control transistor 260 is turned on by the low gate voltage VGL, the path of the driving current may be formed. That is, the driving current may flow from the first power supply voltage ELVDD (through the path of the driving current including the driving transistor 230, the third switching transistor 240, the emission control transistor 260, and the organic light emitting diode 270) to the second power supply voltage ELVSS. Thus, the organic light emitting diode 270 may emit light in response to the driving current flowing through the path.

Further, since the emission data voltage V_DATA applied to each pixel is adjusted to compensate for the degradation of the organic light emitting diode 270, the life time of the pixel may be increased.

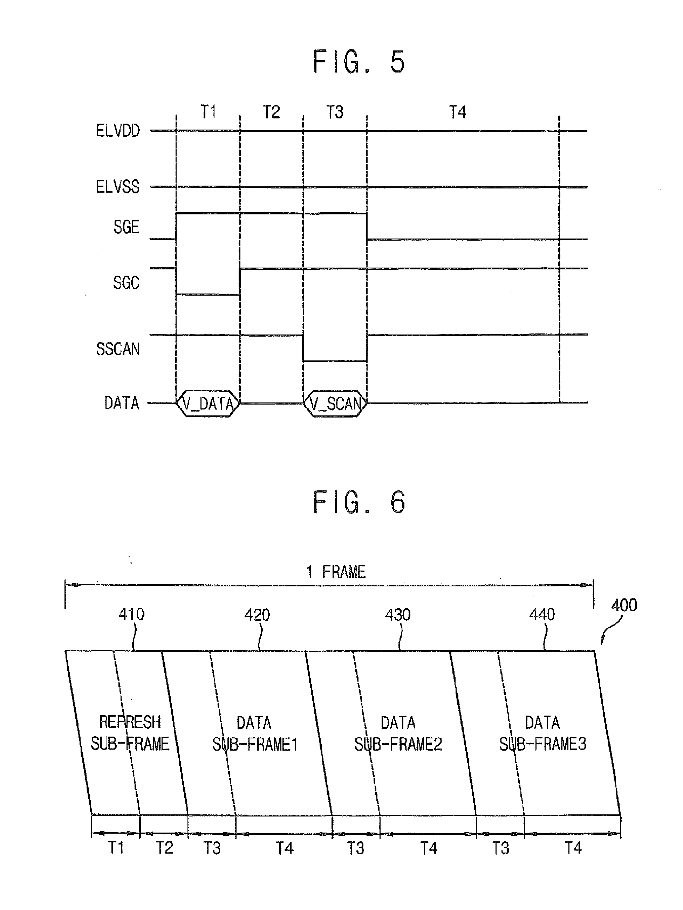

FIG. 4 is a circuit diagram illustrating another embodiment of a pixel of an organic light emitting display device, and FIG. 5 is a timing diagram for describing an operation of a pixel of FIG 4.

Referring to FIG. 4, a pixel of the organic light emitting display device 300 includes first through third switching transistors 310, 320 and 340, a driving transistor 330, a leakage current compensating transistor 380, an emission control transistor 360, first and second storage capacitors 392 and 394, and an organic light emitting diode 370. In some example embodiments, the plurality of switching transistors 310, 320 and 340, the driving transistor 330, the leakage current compensating transistor 380, and the emission control transistor 360 may be implemented by PMOS transistors or NMOS transistors, or a combination of both. The pixel of the organic light emitting display device 300 may have a configuration and operation similar to the pixel 200 of FIG. 2, except that a sensing transistor is not included.

Because the pixel of the organic light emitting display device 300 does not have a sensing transistor, in the sensing period T2 of the refresh sub-frame 110, the emission control transistor 360 may be turned off in response to the high gate voltage VGH and an anode electrode of the organic light emitting diode 370 may be coupled directly to an external device. The level of the degradation of the organic light emitting diode 370 may be measured by sensing the current flowing between the anode electrode and the cathode electrode of the organic light emitting diode 370. This measurement may be taken by an external device.

In some example embodiments, the emission data voltage V_DATA of the next frame may be generated by reflecting the measured level of the degradation of the organic light emitting diode 270. In the initializing period T1 of the refresh sub-frame 110 of the next frame, the degradation of the organic light emitting diode 370 may be compensated using the emission data voltage V_DATA where the measured level of the degradation is reflected.

FIG. 6 illustrates another embodiment of a frame for driving an organic light emitting display device. Referring to FIG. 6, in this embodiment, an organic light emitting display device 400 performs a digital driving method that produces grayscale values with a variable time duration of each of a plurality of pixels. This is accomplished by dividing a frame into at least one refresh sub-frame 410 and a plurality of data sub-frames 420, 430 and 440. The refresh sub-frame 410 may include an initializing period T1 during which an emission data voltage is applied to and stored in each pixel, and a sensing period T2 during which the degradation of an organic light emitting diode of each pixel is detected.

Each data sub-frame 420, 430 and 440 may include a scan period T3 during which a scan data voltage is applied to and stored in each pixel, and an emission period T4 during which the organic light emitting diode of each pixel emits light. In this embodiment one refresh and three data sub-frames are included. However, a different number of refresh and/or data sub-frames may be included in other embodiments.

In the initializing period T1 of each refresh sub-frame 410, a switching signal SGC may be applied to the plurality of pixels at substantially the same time, and the emission data voltage may be received and stored from the data driver. At this time, the emission data voltage may have a voltage level that allows a driving transistor of each pixel to operate in saturation region and that allows the organic light emitting diode to emit light in response to a driving current generated by the driving transistor. Further, the emission data voltage may be adjusted to compensate for the degradation of the organic emitting light diode that is detected during the refresh sub-frame 410 of the previous frame.

In the sensing period T2 of each refresh sub-frame 410, a sensing signal may be applied sequentially, row-by-row, to the plurality of pixels. The degradation of the organic light emitting diode of each pixel may be detected to reflect the detected degradation into the emission data voltage of the next frame. Accordingly, since the degradation of the organic light emitting diode is compensated, a life time of the pixel may be increased.

In the scan period T3 of each data sub-frame 420, 430 and 440, a scan signal from a scan driver may be applied sequentially, row-by-row, to the plurality of pixels. The plurality of pixels may receive and store a scan data voltage transmitted from the data driver. At this time, the scan data voltage may have a voltage level that allows a third switching transistor coupled in series to the driving transistor to operate in a linear region. Further, the scan data voltage applied to each pixel may be either a turn-on voltage that turns on the third switching transistor during the emission period T4 or a turn-off voltage that turns off the third switching transistor during the emission period T4.

In the emission period T4 of each data sub-frame 420, 430 and 440, an emission control signal may be applied sequentially, row-by-row, to the plurality of pixels. The organic light emitting diode of each pixel may emit light or not emit light in response to the stored emission data voltage and the stored scan data voltage. In some example embodiments, as illustrated in FIG. 6, the plurality of pixels included the organic light emitting display device may perform sequential light emission in response to the emission control signal SEM that is applied sequentially, row-by-row, to the plurality of pixels.

As described above, an organic light emitting display device according to example embodiments may divide one frame 400 into at least one refresh sub-frame 410 and the plurality of data sub-frames 420, 430 and 440. In the refresh sub-frame 410, the emission data voltage V_DATA having the voltage level that makes the driving transistor operate in the saturation region and that makes the organic light emitting diode emit light may be applied to the driving transistor. Further, in the refresh sub-frame 410, the degradation of the organic light emitting diode may be detected and may be reflected into the emission data voltage V_DATA of the next frame. Accordingly, since the degradation of the organic light emitting diode of each pixel is compensated, a life time of the pixel may be increased.

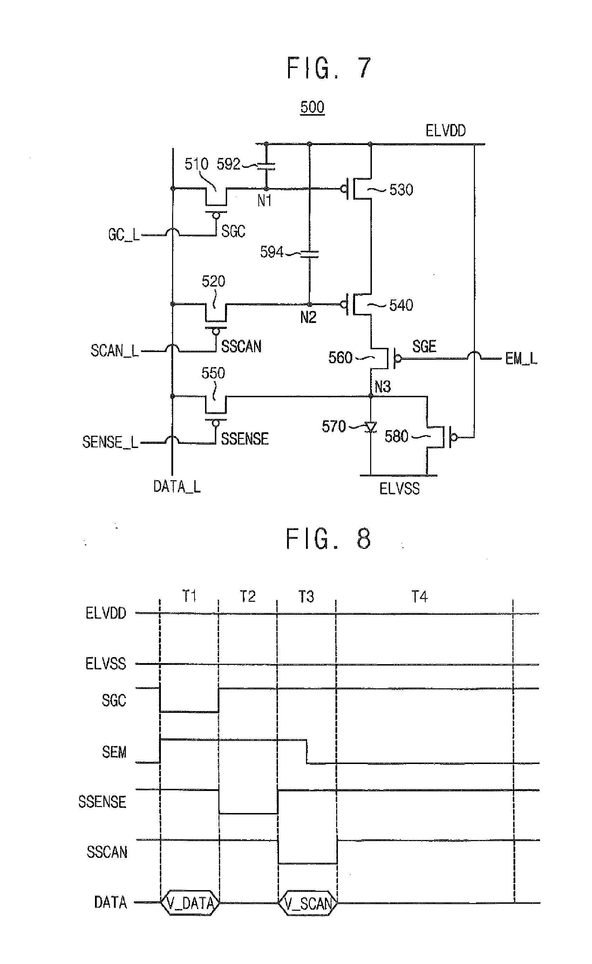

FIG. 7 illustrates another embodiment of a pixel of an organic light emitting display device, and FIG. 8 is a timing diagram for describing an operation of a pixel of FIG. 7.

Referring to FIG. 7, a pixel of the organic light emitting display device 500 includes first through third switching transistors 510, 520 and 540, a driving transistor 530, a sensing transistor 550, a leakage current compensating transistor 580, an emission control transistor 560, first and second storage capacitor 592 and 594, and an organic light emitting diode 570. In some example embodiments, the plurality of switching transistors 510, 520 and 540, the driving transistor 530, the sensing transistor 550, the leakage current compensating transistor 580, and the emission control transistor 560 may be implemented as PMOS transistors or NMOS transistors, or a combination of both. The pixel 500 of FIG. 7 may have configuration and operation similar to the pixel 200 of FIG. 2, except that an emission control signal is applied sequentially, row-by-row, to the emission control transistor of each pixel through an emission control line.

The organic light emitting display device that includes pixels of the FIG. 7 may perform sequential light emission in response to the emission control signal that is applied sequentially, row-by-row, to each pixel through the plurality of the emission control line. The organic light emitting display device that includes pixels of the FIG. 2 may perform a simultaneous light emission in response to the emission control signal that is applied to each pixel through the emission control line from the external at substantially the same time.

Referring to FIGS. 6, 7, and 8, in the scan period T3 of each data sub-frame 420, 430 and 440, a low level voltage (e.g., a low gate voltage VGL) may be applied as the scan signal SSCAN, and the second storage capacitor 594 may store charges corresponding to a scan data voltage V_SCAN. A high level voltage (e.g., a high gate voltage VGH) may be applied as the emission control signal SEM, and the emission control transistor 560 is turned off. Thus, the organic light emitting diode 570 may not emit light.

Further, in the emission period T4 of each data sub-frame 420, 430 and 440, the low level voltage (e.g., low gate voltage VGL) may be applied as the emission control signal SEM through the emission control line EM_L. The emission control transistor 560 may be turned on in response to the low gate voltage VGL.

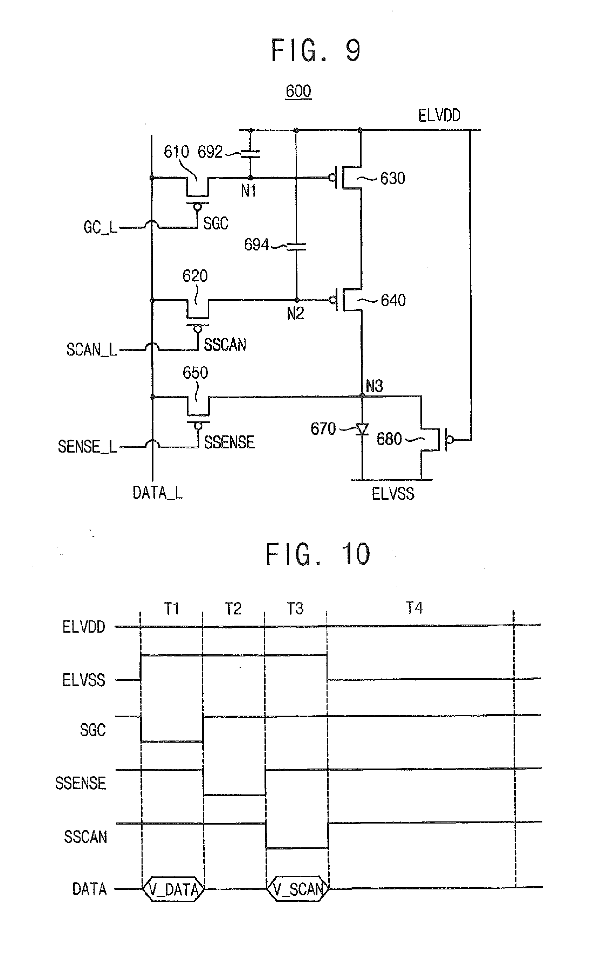

FIG. 9 illustrates another embodiment of a pixel circuit of an organic light emitting display device, and FIG. 10 is a timing diagram for describing an operation of a pixel of FIG 9.

Referring to FIG. 9, a pixel 600 of the organic light emitting display device may includes first through third switching transistors 610, 620 and 640, a driving transistor 630, a sensing transistor 650, a leakage current compensating transistor 680, first and second storage capacitors 692 and 694, and an organic light emitting diode 670. In some example embodiments, the plurality of switching transistors 610, 620 and 640, the driving transistor 630, the sensing transistor 650, and the leakage current compensating transistor 680 may be implemented by PMOS transistors or NMOS transistors, or a combination of both. The pixel 600 of the organic light emitting display device may have configuration and operation similar to the pixel 200 of FIG. 2, except the emission control transistor is not included.

Referring to FIG. 9 and FIG. 10, in the refresh sub-frame, a second power supply voltage ELVSS may have the same voltage level as a first power supply voltage ELVDD. At this time, a current may not be flowing from the first power supply voltage ELVDD to the second power supply voltage ELVSS. Thus, the organic light emitting diode 670 may not emit light. In the refresh sub-frame 410, the organic light emitting diode 670 may not emit light by controlling the second power supply voltage ELVSS even though the drain electrode of the third switching transistor 640 and the organic light emitting diode 670 are connected directly.

As described above, an organic light emitting display device according to the invention may be implemented in various forms. In some example embodiments, a frame for driving the organic light emitting display device may be divided into at least one refresh sub-frame and the plurality of data sub-frames. In the refresh sub-frame, the emission data voltage having the voltage level that makes the driving transistor operate in the saturation region and that makes the organic light emitting diode emit light may be applied to driving transistor. Further, in the refresh sub-frame, the degradation of the organic light emitting diode may be detected and may be reflected into the emission data voltage of the next frame. Accordingly, since the degradation of the organic light emitting diode is compensated, a life time of the pixel may be increased.

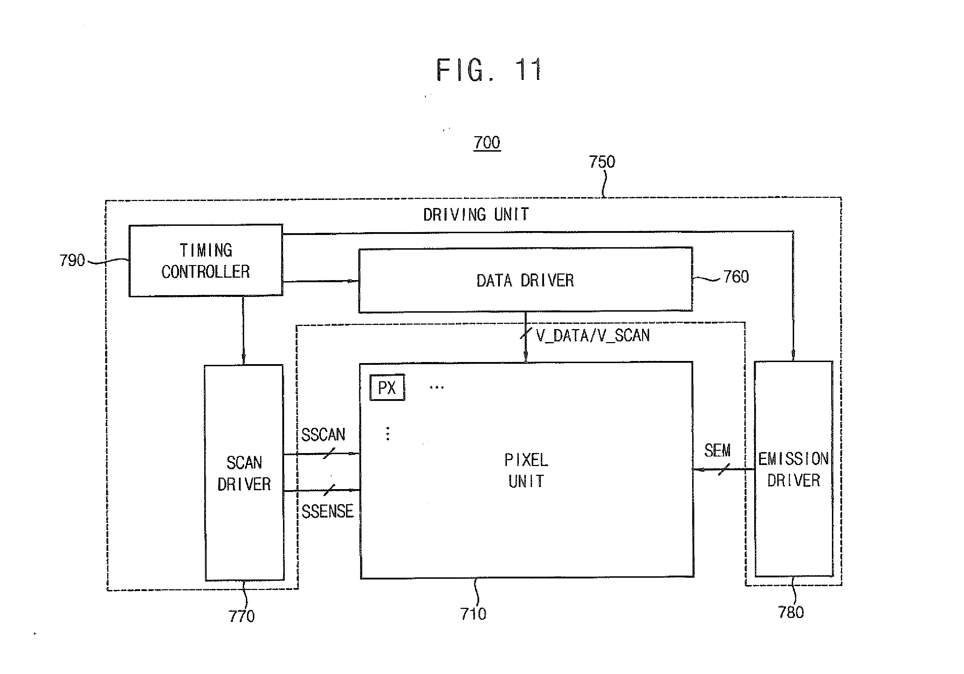

FIG. 11 illustrates an embodiment of an organic light emitting display device 700 which includes a pixel unit 710 containing at least one pixel and PX the driving unit 750.

The pixel unit 710 may be coupled to the data driver 760 of the driving unit 750 through a plurality of data lines, may be coupled to the scan driver 770 of the driving unit 750 through a plurality of scan lines and a plurality of sensing lines, and may be coupled to the emission control driver 780 of the driving unit 750 through a plurality of emission control lines. The pixel unit 710 may include a plurality of pixels PX located at crossing points of the plurality of data lines and the plurality of scan lines.

The driving unit 750 may apply an emission data voltage V_DATA which makes the driving transistor operate in a saturation region and may apply a scan data voltage V_SCAN which makes the organic light emitting diode turn on or turn off to each pixel PX of the pixel unit 710. During one frame, the driving unit 750 may produce grayscale values with a variable time duration of each of a plurality of pixels PX.

Also, the driving unit 750 may drive the pixel unit 710 based on a frame divided into one refresh sub-frame and a plurality of data sub-frames. For example, the driving unit 750 may receive the input data about each pixel PX of the pixel unit 710, may divide one frame into one refresh sub-frame and the plurality of data sub-frames, and may apply the emission data voltage V_DATA corresponding to a value of a corresponding bit of the input data in the refresh sub-frame. At this time, the emission data voltage V_DATA may have a level which makes the driving transistor operate in the saturation region and which makes the organic light emitting diode emit light. Also, in each data sub-frame, the driving unit 750 may apply the scan data voltage V_SCAN.

The driving unit 750 includes a data driver 760, a scan driver 770, and an emission control driver 780. The data driver 760 may apply the emission data voltage V_DATA to the pixel unit 710 through the plurality of data lines in each refresh sub-frame and may apply the scan data voltage V_SCAN to the pixel unit 710 through the data lines in each data sub-frame. The scan driver 770 may apply the scan signal SSCAN to the pixel unit 710 through the plurality of scan lines and may apply the sensing signal SSENSE to the pixel unit 710 through the plurality of sensing lines. The emission control driver 780 may apply the emission control signal SEM to the pixel unit 710 through the plurality of emission control lines.

The timing controller 790 may control an operation of the organic light emitting display device 700. For example, the timing controller 790 may control the operation of the organic light emitting diode 700 by providing control signals to the data driver 760, the scan driver 770 and the emission control driver 780. In some example embodiments, data driver 760, scan driver 770, emission control driver 780, and the timing controller 760 may be implemented with an integrated circuit IC. In other example embodiments, data driver 760, scan driver 770, emission control driver 780, and the timing controller 760 may be implemented with two or more integrated circuits IC.

Embodiments of the invention have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A pixel of an organic light emitting display device, the pixel comprising:
a first switching transistor configured to be turned on in response to a switching signal;
a first storage capacitor configured to store an emission data voltage applied through a data line while the first switching transistor is turned on;
a driving transistor configured to be turned on in response to the emission data voltage stored in the first storage capacitor;
a second switching transistor configured to be turned on in response to a scan signal;
a second storage capacitor configured to store a scan data voltage applied through the data line while the second switching transistor is turned on;
a third switching transistor coupled in series to the driving transistor and configured to be selectively turned on or off in response to the scan data voltage stored in the second storage capacitor; and
an organic light emitting diode configured to be driven by the turned-on driving transistor when the third switching transistor is turned on.

2. A pixel as claimed in claim 1, wherein:
the driving transistor is adapted to operate in a saturation region based on the emission data voltage, and
the third switching transistor is adapted to operate in a linear region based on the scan data voltage.

3. A pixel as claimed in claim 1 or 2, wherein:
the first switching transistor includes a gate terminal to which the switching signal is applied, a first terminal coupled to the data line, and a second terminal coupled to a first node,
the first storage capacitor includes a first electrode coupled to a first power supply voltage and a second electrode coupled to the first node, and
the driving transistor includes a gate terminal coupled to the first node, a first terminal coupled to the first power supply voltage, and a second terminal.

4. A pixel as claimed in claim 3, wherein:
the second switching transistor includes a gate terminal to which the scan signal is applied, a first terminal coupled to the data line, and a second terminal coupled to a second node,
the second storage capacitor includes a first electrode coupled to the first power supply voltage, and a second electrode coupled to the second node, and
the third switching transistor includes a gate terminal coupled to the second node, a first terminal coupled to the second terminal of the driving transistor, and a second terminal.

5. A pixel as claimed in claim 4, wherein:
the organic light emitting diode includes an anode electrode coupled to the second terminal of the third switching transistor and a cathode electrode coupled to a second power supply voltage, and
the second power supply voltage has substantially a same voltage level as the first power supply voltage while the emission data voltage is stored in the first storage capacitor and while the scan data voltage is stored in the second storage capacitor.

6. A pixel as claimed in claim 4 or 5, further comprising:
an emission control transistor coupled between the second terminal of the third switching transistor and the organic light emitting diode.

7. A pixel as claimed in claim 6, wherein:
the emission control transistor is configured to transfer a driving current generated by the turned-on driving transistor to the organic light emitting diode in response to an emission control signal, and
the organic light emitting diode is configured to emit light based on the driving current transferred through the emission control transistor.

8. A pixel as claimed in claim 6 or 7, wherein the emission control transistor includes a gate terminal to which an emission control signal is applied, a first terminal coupled to the second terminal of the third switching transistor, and a second terminal coupled to the organic light emitting diode.

9. A pixel as claimed in any preceding claim, wherein the pixel is adapted to adjust the emission data voltage to compensate for the degradation of the organic light emitting diode.

10. A pixel as claimed in any preceding claim, further comprising:
a sensing transistor configured to detect a current flowing through the organic light emitting diode.

11. A pixel as claimed in claim 10, wherein, the emission data voltage is adjusted based on the current detected by the sensing transistor, the adjusted emission data voltage compensating for a degradation of the organic light emitting diode.

12. A pixel as claimed in claim 11, wherein the sensing transistor includes:
a gate terminal to which a sensing signal is applied,
a first terminal coupled to the data line, and
a second terminal coupled to an anode electrode of the organic light emitting diode.
